# EUROPEAN PATENT APPLICATION

(11) **EP 4 654 099 A1**
(43) Date of publication of application: **26.11.2025**
(21) Application number: 25170626.3
(22) Date of filing: 15.04.2025
(51) Int. Cl.: G06Q 10/04, G06Q 10/0637, G06Q 10/0639, G06Q 30/0201, G06Q 30/0202, G06Q 30/0203, G06Q 50/40

(54) **INFORMATION PROCESSING PROGRAM, INFORMATION PROCESSING METHOD, AND INFORMATION PROCESSING DEVICE**

(30) Priority: 20.05.2024 JP 2024081965
(71) Applicant: FUJITSU LIMITED, Kawasaki-shi, Kanagawa 211-8588 (JP)
(72) Inventor: OGAI, Yusaku, Kawasaki-shi, Kanagawa, 211-8588 (JP); OKABAYASHI, Miwa, Kawasaki-shi, Kanagawa, 211-8588 (JP)
(74) Representative: Hoffmann Eitle

(57) **Abstract**

An information processing program causes a computer (10) to execute a process. The process includes causing an agent corresponding to a person present in a real world to generate use experience of a service by performing a simulation regarding use of the service by the agent corresponding to the person in a digital twin in which the real world is reproduced on a virtual space. The process includes setting information regarding use intention of the service possessed by the agent corresponding to the person based on the generated use experience.

## Description

### FIELD

The embodiments discussed herein are related to an information processing program, an information processing method, and an information processing device.

### BACKGROUND

Before providing a new service, a questionnaire may be used as market research. For example, use experience of a service is investigated by a questionnaire, and details of a service providing method are determined.

In addition, there is a technology called a digital twin as a technology for representing an object existing in a physical space of the real world in a virtual space. The digital twin includes a technique called an agent-based model that virtually reproduces people, objects, and time and space and simulates their interaction. It is known that such an agent-based model can be combined with survey by questionnaire to reproduce use experience of a service in simulation.

Patent Document 1: Japanese Laid-open Patent Publication No. 2016-076125

Here, in order to estimate use intention indicating whether people want to use a service on the basis of a change in use experience of a service, it is important to investigate a questionnaire before and after actually implementing some service measures. However, if a questionnaire is investigated as an effect verification while implementing measures, there is a problem that cost is required in terms of time and cost.

Accordingly, it is an object in one aspect of an embodiment of the present invention to enable a service measure to be determined without cost.

### SUMMARY

According to an aspect of an embodiment, an information processing program causes a computer (10) to execute a process. The process includes causing an agent corresponding to a person present in a real world to generate use experience of a service by performing a simulation regarding use of the service by the agent corresponding to the person in a digital twin in which the real world is reproduced on a virtual space. The process includes setting information regarding use intention of the service possessed by the agent corresponding to the person based on the generated use experience.

### BRIEF DESCRIPTION OF DRAWINGS

FIG. 1 is a diagram illustrating a reference example of a deployment measure of mobility sharing;
FIG. 2 is a diagram illustrating a reference example of simulating use intention of a service;
FIG. 3 is a diagram illustrating an example of a flow of simulation according to the present embodiment;
FIG. 4 is a diagram illustrating a configuration example of an information processing system according to the present embodiment;
FIG. 5 is a diagram illustrating an example of a functional configuration of an information processing device according to the present embodiment;
FIG. 6 is a diagram illustrating an example of action selection model generation processing according to the present embodiment;
FIG. 7 is a diagram illustrating an example of use intention estimation according to the present embodiment;
FIG. 8 is a diagram illustrating an image of movement reproduction processing according to the present embodiment;
FIG. 9A is a diagram (1) illustrating an example of use experience update processing according to the present embodiment;
FIG. 9B is a diagram (2) illustrating an example of the use experience update processing according to the present embodiment;
FIG. 9C is a diagram (3) illustrating an example of the use experience update processing according to the present embodiment;
FIG. 10 is a diagram illustrating an example of measure evaluation processing according to the present embodiment;
FIG. 11 is a diagram illustrating an example of a flowchart of simulation according to the present embodiment;
FIG. 12 is a diagram illustrating a specific example of use experience update according to the present embodiment;
FIG. 13 is a diagram illustrating an example of a flowchart of measure evaluation processing according to the present embodiment;
FIG. 14A is a diagram (1) illustrating a specific example of measure evaluation according to the present embodiment;
FIG. 14B is a diagram (2) illustrating a specific example of measure evaluation according to the present embodiment;
FIG. 15 is a diagram illustrating an example of an effect of simulation according to the present embodiment; and
FIG. 16 is a diagram for explaining a hardware configuration example of the information processing device.

### DESCRIPTION OF EMBODIMENTS

Preferred embodiments of the present invention will be explained with reference to accompanying drawings. Note that the present embodiment is not limited to the embodiments. In addition, the embodiments can be appropriately combined within a range without inconsistency.

First, a deployment measure of mobility sharing will be described, which indicates how to implement redeployment of vehicles in a sharing service of vehicles (mobility) which has not been widely used.

### Reference example of deployment measure of mobility sharing

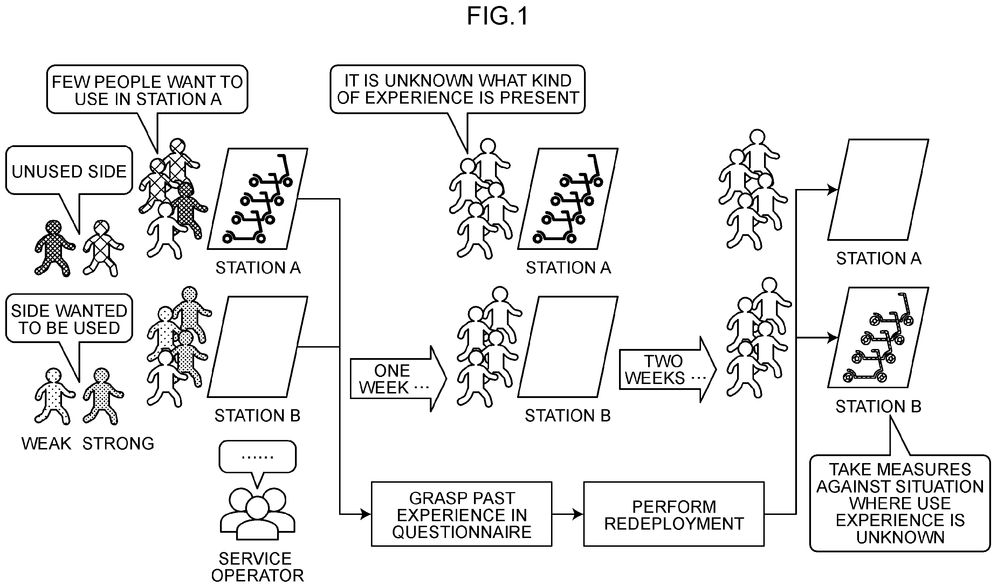

FIG. 1 is a diagram illustrating a reference example of a deployment measure of mobility sharing. For example, when a mobility sharing service is introduced to a new area, it is difficult to determine how many vehicles need to be deployed. Therefore, intention investigation by questionnaire is performed. The use experience of a service changes even after the intention survey period by the questionnaire and the measure for redeployment.

For example, it is assumed that an operator of a mobility sharing service grasps past use experience through a questionnaire. In a station A, there are few people who want to use the vehicle provided by the service, but there are many deployed vehicles. On the other hand, in a station B, there are many people who want to use the vehicle provided by the service, but there are few deployed vehicles. Therefore, the service operator performs redeployment on the basis of the grasped information. However, since the use experience of a service changes, a measure for redeployment is implemented in a situation where the use experience of a service is unknown.

Here, in order to estimate use intention indicating whether people want to use a service on the basis of a change in the use experience of a service, it is important to investigate a questionnaire before and after actually implementing a redeployment measure. However, if a questionnaire is investigated as an effect verification while implementing measures for redeployment, there is a problem that cost is required in terms of time and cost. That is, it is not realistic to conduct the questionnaire survey a plurality of times in a short period of time.

Therefore, it is known that such an agent-based model can be combined with survey by questionnaire to reproduce use experience of a service in simulation. For example, a technique of "Simulation analysis on the introduction possibility of a one-way micro electric vehicle (MEV) sharing system" is disclosed (see https://doi.org/10.2208/jscejipm.71.I_805). In such a technology, the possibility of introducing a one-way sharing system that does not perform redeploying (can leave) is examined by constructing a replacement model of trip and operational simulation analysis. Therefore, SP investigation assuming sharing by MEV has been designed and implemented. Furthermore, an operation simulation program using a model has been developed, and the possibility of introduction has been examined.

Reference examples using such a technique are as follows. The information processing device estimates an action selection model from a survey result of a questionnaire. The questionnaire is information obtained by investigating decision making (use intention) with respect to a level of service (LOS). The LOS means a number representing a level of service such as a fee, the number of vehicles, and a probability that a service cannot be used. Then, the information processing device verifies the influence of the LOS on the use of the service by agent simulation. In the agent simulation, the LOS (here, the number of vehicles, the probability that the service cannot be used, and the like) changes from moment to moment depending on the use result of the service, and the decision making (use intention) also changes depending on the change.

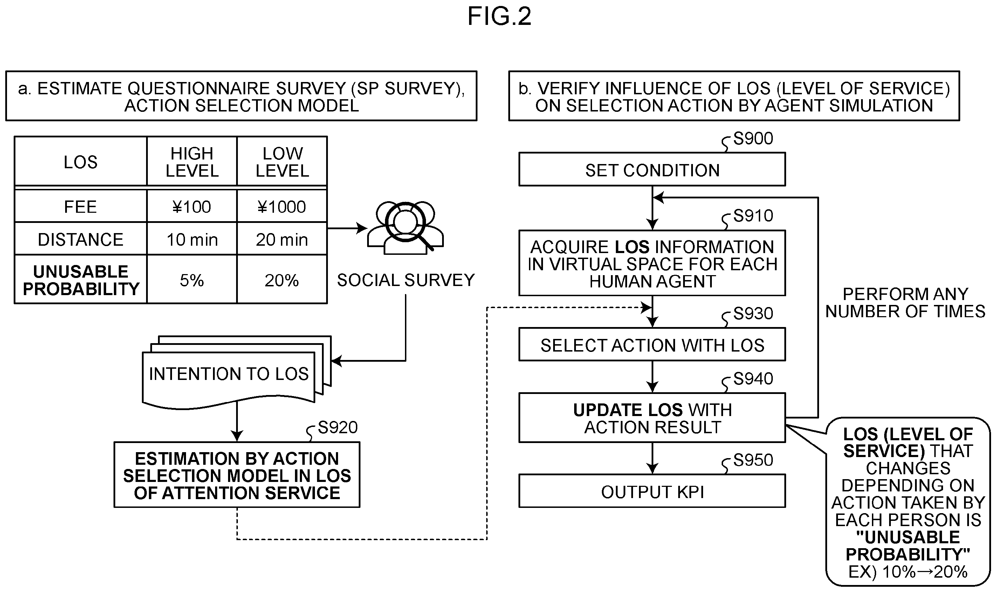

FIG. 2 is a diagram illustrating a reference example of simulating use intention of a service. In the left part of FIG. 2, the information processing device generates an action selection model for estimating an action from a survey result of a questionnaire. For example, the information processing device generates an action selection model for estimating an action using a questionnaire that investigates the use intention for a LOS of a service.

In the right part of FIG. 2, the information processing device verifies the influence of the LOS on the action by agent simulation. For example, the information processing device sets a condition for executing the agent simulation (S900). Then, the information processing device acquires information on the LOS of the virtual space for each agent with respect to a person (S910). In order to select an action with the LOS, the information processing device inputs information of the LOS to the action selection model and estimates the action (S920, S930). The information processing device updates the LOS on the basis of the action result of the action in the virtual space (S940). Here, the LOS that changes depending on the action taken by the agent corresponding to the person is a probability that the service cannot be used or the like. Then, the information processing device repeats processing of acquiring information of the LOS (S910), action estimation processing (S930), and processing of updating the LOS (S940) an arbitrary number of times, and outputs a Key Performance Indicator (KPI) (S950). The KPI is an evaluation index indicating a verified result. As a result, the information processing device can reproduce the change in the LOS in the simulation and reproduce the use intention based on the changed LOS. In addition, since the information processing device handles LOS by numbers, interpretation is easy.

### Problems of reference example

However, in the reference example, the use intention based on the changed LOS can be reproduced, but subjective meaning such as good or bad for the changed LOS is not considered. That is, in the reference example, evaluation of experience in action is not considered. Therefore, in the technology of the reference example, a change in evaluation of experience is not included in consideration.

Therefore, in the embodiment, a description will be given of a simulation method capable of determining a service measure while estimating the evaluation of the use experience of a service and the change in the use intention of the service according to the measure and virtually verifying the effect of the service measure. That is, a description will be given of a simulation method in which service measures can be determined without reviewing a questionnaire.

Note that the simulation method described below will be described in the case of a mobility sharing service. In addition, the target mobility of the mobility sharing service is, for example, an electric scooter or an electric bicycle, but is not limited thereto, and may be a sharing target vehicle that has not been widely used yet.

### Example of flow of simulation by information processing device

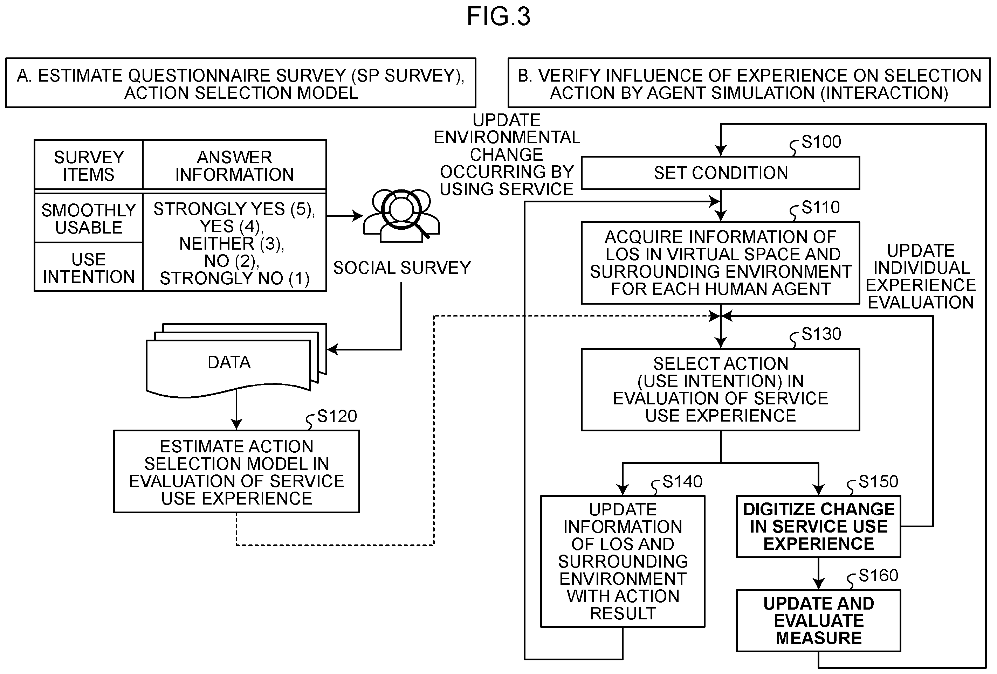

FIG. 3 is a diagram illustrating an example of a flow of simulation according to the present embodiment. Such a simulation is an agent simulation regarding use of a service by an agent corresponding to a person existing in the real world in the digital twin that reproduces the real world on a virtual space. The simulation generates use experience of a service for the agent for the person.
Then, in the simulation, information regarding use intention indicating whether the agent corresponding to the person desires to use the service is set and updated on the basis of the generated use experience.

In the left part of FIG. 3, an information processing device 10 generates an action selection model for estimating an action from answer information for each survey item of the questionnaire. Note that an ordered logit, an ordered probit, or the like may be applied as the action selection model. For example, the information processing device 10 generates an action selection model for estimating an action (use intention) by using answer information for each survey item of the questionnaire and answer information of use intention. The answer information includes subjective data and is represented by, for example, 1 to 5 graduated numbers. In addition, the number 1 to 5 of the answer information can be changed, and the depth of the stage of the answer information can also be changed.

In the right part of FIG. 3, the information processing device 10 verifies the influence of experience on action by agent simulation. For example, the information processing device 10 sets a condition for executing the agent simulation (S100). The conditions mentioned here are conditions as measures, and examples thereof include the number of vehicles (the number of deployed vehicles) to be deployed for each station of a mobility of a service target.

The information processing device 10 acquires information on the LOS of the virtual space and information on the surrounding environment for each agent corresponding to a person (S110). The information of the surrounding environment is, for example, information such as a vehicle situation and a road situation.

In order to select an action corresponding to a person, the information processing device 10 inputs evaluation information of the use experience of a service to the action selection model and estimates an action (use intention) (S120, S130). Here, the evaluation information of the use experience of a service is information in which the experience of using the service in the simulation is reflected in the answer information for each survey item of the questionnaire. In the first time, the evaluation information of the use experience of a service is answer information for each survey item of the questionnaire immediately after the survey.

Then, the information processing device 10 updates the information regarding the LOS and the surrounding environment with the action result of the action in the virtual space (S140). Then, the information processing device 10 proceeds to step S110 to update the information on the environmental change caused by using the service.

Furthermore, the information processing device 10 digitizes the change in the use experience of a service obtained from the action result of the action on the virtual space (S150). Then, the information processing device 10 proceeds to step S130 to update the digitized change in the use experience of a service. That is, the information processing device 10 creates a loop structure of estimating the use intention of the service on the basis of the information on the changed service use experience, so that the use intention of the service can be estimated on the basis of the changed mind after the agent corresponding to the person changes his/her mind to the service.

Then, the information processing device 10 evaluates the measures using the use experience of a service (S160). The measures mentioned here refer to, for example, adjusting the number of deployed vehicles of the mobility of the service target, adjusting recovery of the battery of the mobility of the service target, and the like. That is, the information processing device 10 can cause the operator of the service to examine the quality of the measure plan obtained by the evaluation by using the use experience of a service for the evaluation of the measure. Then, the information processing device 10 updates the evaluation result to a condition (S160).

As a result, the information processing device 10 can update the change in the use experience of a service without reviewing the questionnaire by generating the use experience of a service by simulation and reflecting the use experience in the agent. Furthermore, the information processing device 10 can determine a measure for a service at no cost. That is, the operator of the service can examine a measure plan while performing error in execution based on a change in the use intention of the virtual service.

### Functional configuration of information processing system

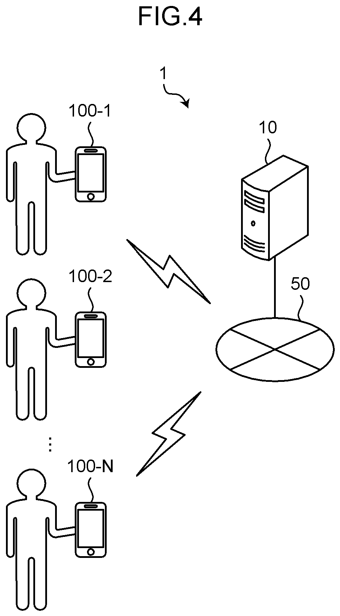

Next, an information processing system for implementing the present embodiment will be described. FIG. 4 is a diagram illustrating a configuration example of the information processing system according to the present embodiment. As illustrated in FIG. 4, an information processing system 1 is, for example, a system in which the information processing device 10 and information processing terminals 100-1 to 100-N (N is an arbitrary natural number, and is hereinafter collectively referred to as an "information processing terminal 100") are connected to each other so as to be usable via a network 50.

As the network 50, various communication networks such as the Internet can be adopted. Furthermore, the network 50 is not a single network, and for example, an intranet and the Internet may be configured via a network device such as a gateway or another device (not illustrated).

The information processing terminal 100 is, for example, a mobile terminal such as a smartphone or a tablet personal computer (PC) carried by a respondent of the questionnaire. In the information processing terminal 100, for example, an application for answering a questionnaire may be installed in advance. Then, the information processing terminal 100 may display a questionnaire screen via the application and the respondent may answer the questionnaire, for example. Alternatively, the information processing terminal 100 may access, for example, a website or an application for carrying out a questionnaire and the respondent may answer the questionnaire. In this case, an application for answering the questionnaire does not need to be installed in the information processing terminal 100.

The information processing device 10 is, for example, an information processing device such as a desktop PC, a notebook PC, or a server computer installed in a facility such as a service operating company and used by a service operator or the like. Note that, in FIG. 4, the information processing device 10 is illustrated as one computer, but may be a distributed computing system including a plurality of computers. Furthermore, the information processing device 10 may be a cloud computer device managed by a service provider that provides a cloud computing service.

### Functional configuration of information processing device

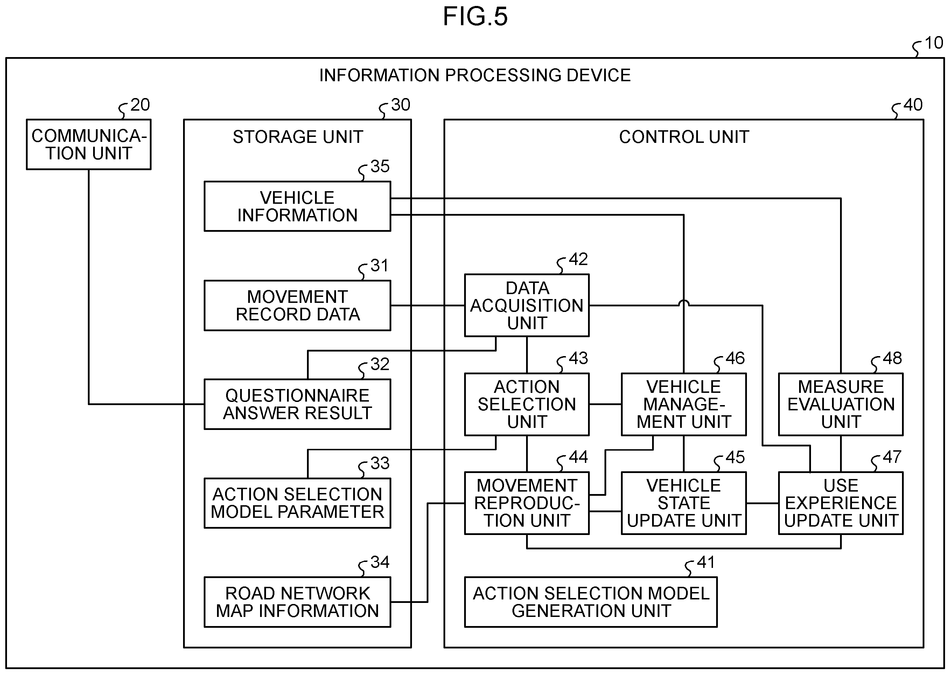

Next, a functional configuration of the information processing device 10 will be described. FIG. 5 is a diagram illustrating an example of a functional configuration of the information processing device according to the present embodiment. As illustrated in FIG. 5, the information processing device 10 includes a communication unit 20, a storage unit 30, and a control unit 40.

The communication unit 20 is a processing unit that controls communication with another information processing device such as the information processing terminal 100, and is, for example, a communication interface such as a network interface card or a universal serial bus (USB) interface.

The storage unit 30 has a function of storing various data and a program executed by the control unit 40, and is realized by, for example, a storage device such as a memory or a hard disk. The storage unit 30 stores movement record data 31, a questionnaire answer result 32, an action selection model parameters 33, road network map information 34, vehicle information 35, and the like.

The movement record data 31 is data indicating a movement record for each agent corresponding to a person. The movement record data 31 includes information such as a departure place, a destination, a departure time, time for each movement, and position information for each agent corresponding to a person. The position information is represented by, for example, coordinate data on a map in the road network map information 34 described later. In addition, the departure place, the destination, and the departure time are acquired from, for example, the questionnaire answer result 32 of a questionnaire to be described later.

The questionnaire answer result 32 is data of an answer result corresponding to a survey item regarding the use intention and use experience of the service. Note that the survey items of the questionnaire include not only use intention and use experience of the service but also social attribute information such as age and sex, and information on movement and transportation means actually used. Such information may include information such as a departure place, a destination, and a departure time of a moving source. The questionnaire answer result 32 is an example of information regarding the use intention of the service.

Examples of the survey items of the use experience of the questionnaire include "Do you think you can use the service smoothly?", "Do you think the number of vehicles is plenty?", and the like. Examples of the survey items regarding the use intention of the questionnaire include "Do you want to use the service?" and the like. The answer information of the questionnaire is represented, for example, in 1 to 5 steps one by one.

The action selection model parameter 33 is a parameter used in the action selection model. The action selection model parameter 33 is a coefficient for explaining the use intention of the service, and is set for each explanatory variable corresponding to the survey item. Note that the action selection model parameter 33 is set in advance before training. The action selection model parameter 33 will be described later.

The road network map information 34 is information representing a road network on a map. For example, the road network data may be acquired from an open street map (OSM) or the like. The map data may be acquired from, for example, a Folium library or the like.

The vehicle information 35 is information on mobility (vehicle) shared by the mobility sharing service. For example, the vehicle information 35 includes, for each station, the number of deployed vehicles as a sharing target, the inventory quantity, the upper limit number of vehicles, the number of rent vehicles, the number of returned vehicles, position information of each station, and the like. Examples of the vehicle to be shared include an electric scooter and an electric bicycle. Note that the "number of vehicles to be deployed" mentioned here refers to the number of deployed vehicles in the station by measures. The "inventory quantity" refers to the number of vehicles present in the station.

The control unit 40 includes an action selection model generation unit 41, a data acquisition unit 42, an action selection unit 43, a movement reproduction unit 44, a vehicle state update unit 45, a vehicle management unit 46, a use experience update unit 47, and a measure evaluation unit 48. Note that the action selection unit 43, the movement reproduction unit 44, the vehicle state update unit 45, and the vehicle management unit 46 are examples of the simulation unit. The use experience update unit 47 is an example of a setting unit.

The action selection model generation unit 41 generates an action selection model using the questionnaire answer result 32. For example, the action selection model generation unit 41 generates an action selection model by training data related to the use experience of a service of the questionnaire answer result 32 as a feature amount and data related to the use intention of the service of the questionnaire answer result 32 as a correct answer label.

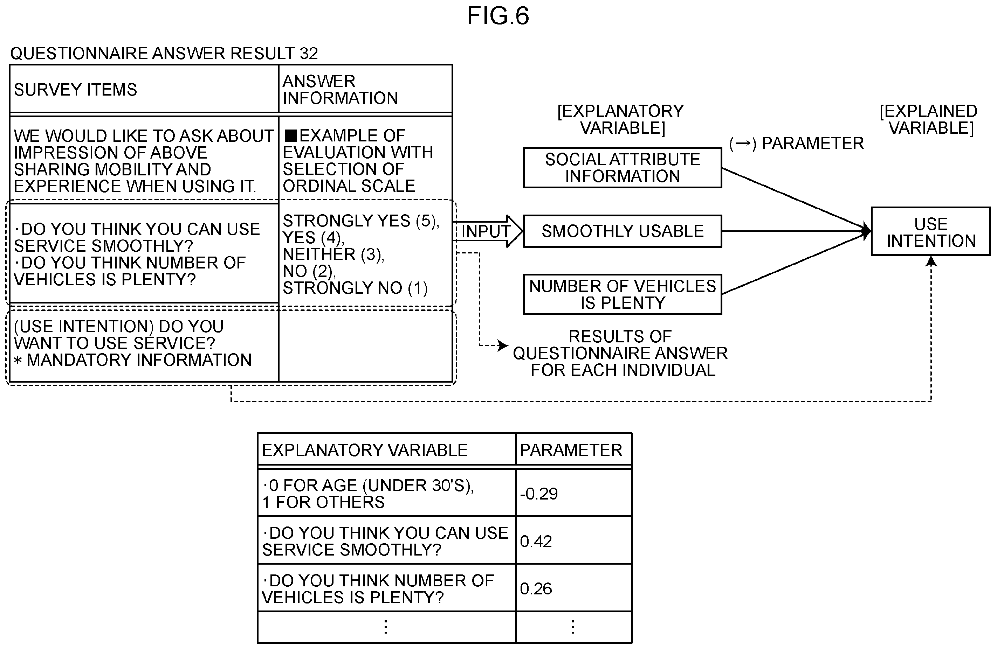

Here, an example of the action selection model generation processing will be described with reference to FIG. 6. FIG. 6 is a diagram illustrating an example of the selection action model generation processing according to the present embodiment. As illustrated in FIG. 6, the questionnaire answer result 32 is illustrated. The action selection model generation unit 41 trains the data regarding the use experience of a service of the questionnaire answer result 32 as an explanatory variable and the data regarding the use intention of the service of the questionnaire answer result 32 as an explained variable. Here, the action selection model generation unit 41 trains answer information indicating whether the service can be smoothly used, answer information indicating whether the number of vehicles is plenty, and social attribute information indicated in the questionnaire answer result 32 as explanatory variables, and answer information indicating the use intention indicated in the questionnaire answer result 32 as explained variables. The parameter corresponding to the explanatory variable is stored in the action selection model parameter 33 and set in the action selection model. Then, the action selection model generation unit 41 inputs information regarding the use experience of a service and generates an action selection model for estimating the use intention of the service.

Here, parameters will be described. The parameter is a coefficient for explaining the use intention of the service, and is set for each explanatory variable corresponding to the survey item. In a case where the parameter is a positive value, it means that there is a relationship in which the possibility of use intention increases as the value (1 to 5) of the explanatory variable increases. In a case where the parameter is a negative value, it means that there is a relationship in which the possibility of use intention decreases as the value (1 to 5) of the explanatory variable increases. Here, in a case where the explanatory variable is "Do you think you can use the service smoothly?", since the parameter is a positive value (0.42), the possibility of use intention increases as the value of the explanatory variable increases. On the other hand, in a case where the explanatory variable is "age...", since the parameter is a negative value (-0.29), the possibility of use intention decreases as the value of the explanatory variable increases.

Returning to FIG. 5, the data acquisition unit 42 acquires data used to perform simulation in the agent corresponding to a person. For example, the data acquisition unit 42 acquires the departure place, the destination, the departure time, and the position information of the agent corresponding to a target person from the movement record data 31. In addition, the data acquisition unit 42 acquires the questionnaire data of the target person from the questionnaire answer result 32. The questionnaire data includes data regarding the use experience of a service and data regarding the social attribute information. In other words, the data acquisition unit 42 acquires data for generating an agent to be aggregated as information on an individual basis.

The action selection unit 43 selects an action using the action selection model. For example, the action selection unit 43 inputs questionnaire data of a target person to a trained action selection model, and estimates the use intention of the service. Then, the action selection unit 43 selects a moving means by using the use intention of the service and the coordinate data of the target person. As an example, in a case where the use intention of the service indicates to use the service, the action selection unit 43 inquires of the vehicle management unit 46 to be described later whether the target person can rent the service vehicle from the coordinate data of the target person. In a case where the service vehicle can be rented, the action selection unit 43 sets the service vehicle as a moving means. In a case where the use intention of the service indicates that the service is not used, or in a case where the vehicle of the service cannot be rented, the action selection unit 43 acquires information of another moving means from the movement record data 31 and sets the vehicle as the acquired moving means.

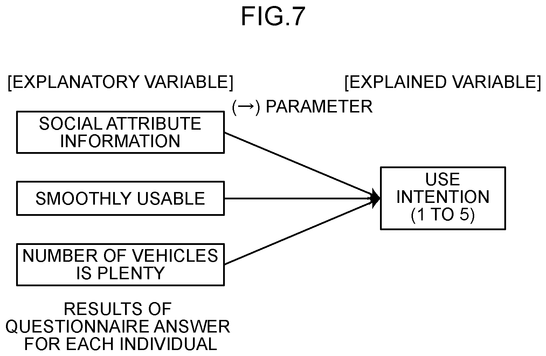

Here, an example of the use intention estimation will be described with reference to FIG. 7. FIG. 7 is a diagram illustrating an example of use intention estimation according to the present embodiment. The action selection unit 43 inputs questionnaire data of a target person into a trained action selection model, and estimates the use intention of the service. As illustrated in FIG. 7, the action selection unit 43 inputs social attribute information in the questionnaire answer result 32 of the target person and data regarding service use experience to the trained action selection model as explanatory variables. Here, the data regarding the use experience of a service is answer information indicating whether the service can be smoothly used and answer information indicating whether the number of vehicles is plenty. Then, the action selection unit 43 estimates the use intention using the trained action selection model. That is, the action selection unit 43 estimates the use intention (1 to 5) using the value (1 to 5) of the explanatory variable and the value of the parameter associated with the explanatory variable.

Returning to FIG. 5, the movement reproduction unit 44 reproduces the movement of a person or mobility in the digital twin. For example, the movement reproduction unit 44 reproduces, on a virtual space, an object corresponding to the facility obtained from the social attribute information and the vehicle information 35 of the target person. As an example, the virtual space mentioned here may be generated from map data and road network data. Furthermore, the facility mentioned here includes, for example, a home of a target person, a service station, and the like. Then, the movement reproduction unit 44 arranges an agent corresponding to the target person in the virtual space in the digital twin, and associates the arranged agent with the social attribute information such as the current coordinates, the current time, the departure place, the destination, the departure time, and the age and gender, and questionnaire data including questionnaire answers.

In addition, the movement reproduction unit 44 determines a movement route corresponding to a moving means on the road network from a departure place and a destination associated with the agent by using a route generation tool. As an example, the route generation tool may be any tool or library that can use a route generation algorithm such as an open trip planner or OSMNX. Then, the movement reproduction unit 44 reproduces the movement of the agent along the movement route by the moving means on the virtual space. That is, the movement reproduction unit 44 reproduces the experience of the service by the agent corresponding to the person by simulation.

In addition, the movement reproduction unit 44 notifies the use experience update unit 47 of the movement distance moved by the moving means, the route information, and the use experience information. Examples of the use experience information include "the inventory quantity for sharing as a moving means is small" and "I couldn't use sharing", "the inventory quantity for sharing as a moving means is large", and "I was able to use sharing". Furthermore, examples of the use experience information include "station is crowded" and "station is less crowded".

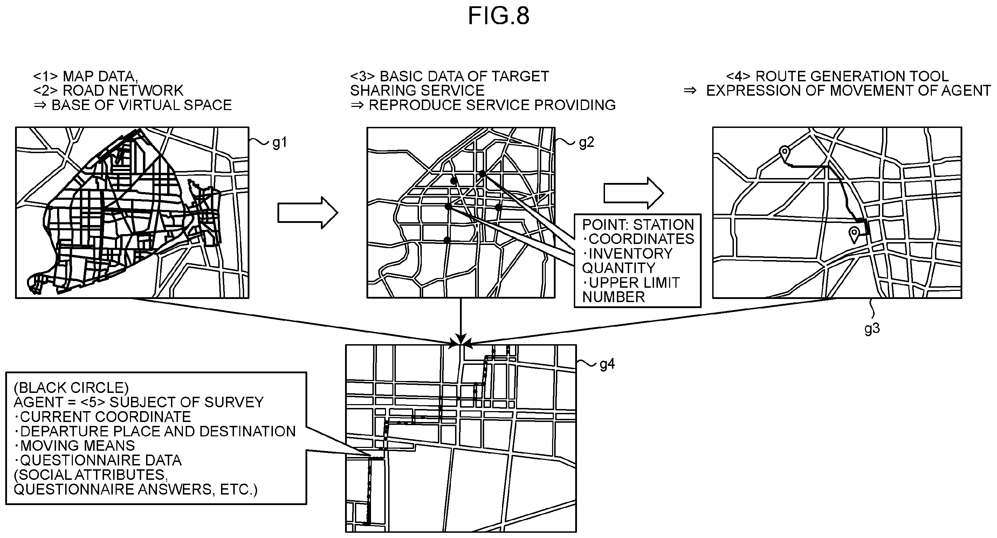

Here, an image of the movement reproduction processing will be described with reference to FIG. 8. FIG. 8 is a diagram illustrating an image of the movement reproduction processing according to the present embodiment. As indicated by reference numeral g1 in FIG. 8, the movement reproduction unit 44 generates a base of the virtual space using the road network map information 34 in the digital twin. The virtual space may be generated, for example, from <1> map data and <2> road network data in the road network map information 34.

Next, as indicated by reference numeral g2, the movement reproduction unit 44 reproduces <3> the basic data of the target sharing service on the base of the virtual space in order to reproduce the provision of the service. For example, the movement reproduction unit 44 reproduces the object corresponding to the station obtained from the vehicle information 35 in the virtual space. Then, the movement reproduction unit 44 sets, for example, coordinate data of the station, the number of deployed vehicles, the inventory quantity, the upper limit number of vehicles, and the like in the object corresponding to the station. The reference numeral g2 represents a station.

Next, as indicated by reference numeral g3, the movement reproduction unit 44 uses <4> route generation tool to determine a movement route according to the moving means on <2> road network in order to express the movement of the agent. For example, the movement reproduction unit 44 acquires a departure place and a destination from questionnaire data of an agent corresponding to a person, and determines a movement route according to a moving means on <2> road network using the route generation tool.

Then, as indicated by reference numeral g4, the movement reproduction unit 44 reproduces, in the virtual space, the movement of the agent corresponding to the target person from the departure place to the destination by the moving means. A plurality of black point groups indicated by reference numeral g4 are trajectories in which the agent corresponding to the target person moves. The movement reproduction unit 44 stores time and coordinate data for each movement in the movement record data 31 corresponding to the agent.

Returning to FIG. 5, the vehicle state update unit 45 updates the vehicle state of the moving means of the target sharing service. For example, in a case where the moving means is a service target vehicle, the vehicle state update unit 45 calculates the state of the vehicle such as a battery according to the movement distance after the movement by the vehicle. In addition, the vehicle state update unit 45 searches for the return destination information of the vehicle according to the coordinate data of the destination after the movement by the vehicle.

Then, the vehicle state update unit 45 outputs the remaining battery level and the return destination information of the vehicle to the vehicle management unit 46.

In addition, the vehicle state update unit 45 notifies the use experience update unit 47 of the service use experience information such as the remaining battery level.

The vehicle management unit 46 manages a vehicle.

For example, the vehicle management unit 46 determines whether the target person can rent the vehicle for the sharing service from the coordinate data of the target person according to the inquiry by the action selection unit 43. As an example, the vehicle management unit 46 refers to the vehicle information 35 and acquires the inventory quantity corresponding to the station close to the departure place of the target person. Then, the vehicle management unit 46 determines whether a service vehicle can be rented out by using the acquired inventory quantity. Then, in a case where the vehicle of the service can be rented, the vehicle management unit 46 rents the service vehicle, notifies the action selection unit 43 of the inquiry source that the vehicle has been rented, and decrements the inventory quantity corresponding to the corresponding station stored in the vehicle information 35. Note that, in a case where a service vehicle cannot be rented, the vehicle management unit 46 notifies the inquiry source action selection unit 43 that the service vehicle cannot be rented.

When receiving the vehicle return destination information from the vehicle state update unit 45, the vehicle management unit 46 increments the inventory quantity corresponding to the corresponding station so as to return the target vehicle to the target station. When receiving the remaining battery level of the vehicle from the vehicle state update unit 45, the vehicle management unit 46 updates the remaining battery level of the vehicle returned to the corresponding station.

The use experience update unit 47 updates the evaluation information of the use experience of a service. For example, the use experience update unit 47 evaluates the use experience of a service by the agent corresponding to the target person. The use experience of a service is evaluated, for example, for each survey item (explanatory variable) of the questionnaire. Then, the use experience update unit 47 adds or subtracts the value to or from the value of the answer information of the questionnaire according to the use experience, and updates the value. Then, the use experience update unit 47 updates the evaluation information to the questionnaire answer result 32.

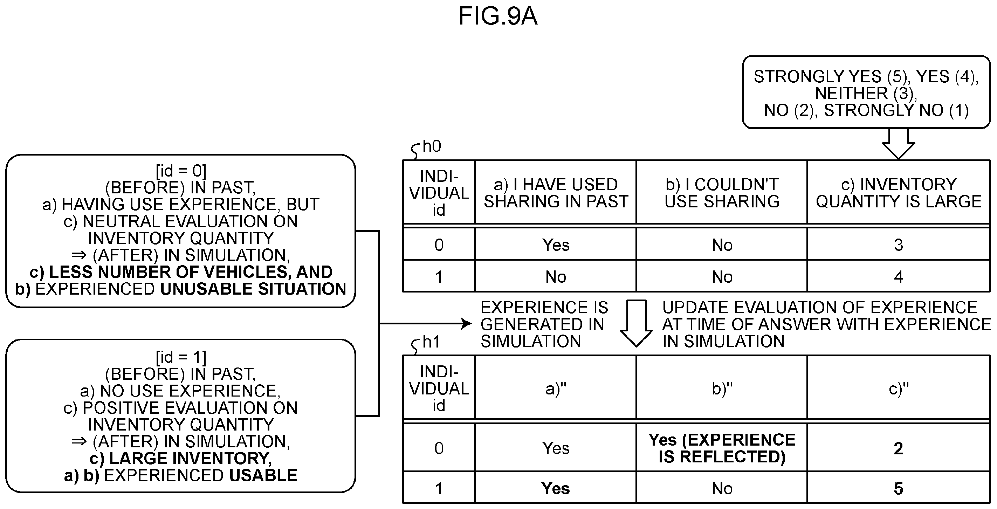

Here, an example of the use experience update processing will be described with reference to FIGS. 9A to 9C. FIGS. 9A to 9C are diagrams illustrating an example of the use experience update processing according to the present embodiment.

As illustrated in FIG. 9A, the individual ids "0" and "1" are ids for identifying a person. h0 is the questionnaire answer result 32 set by the experience at the time of answering the questionnaire. h1 is the questionnaire answer result 32 updated by the experience generated by the simulation. In a case where the individual id is "0", for "a) Have you used sharing in the past?", "Yes" indicating that the sharing has been used is set. For the survey item "b) Were you not able to use sharing?", "No" indicating that the user could use sharing is set. For the survey item "c) Do you think the inventory quantity is large?", "3" indicating that the survey item is neither is set.

Under such circumstances, it is assumed that an experience of a situation in which the number of vehicles in the simulation is small and sharing is not able to be used has occurred for a person whose individual id is "0". Then, the use experience update unit 47 adds or subtracts the value to or from the value of the answer information of the questionnaire according to the use experience, and updates the value. Here, according to the experience generated by the simulation, for the survey item "b) Were you not able to use sharing?", "Yes" indicating that the user could not use sharing is updated. For the survey item "c) Do you think the inventory quantity is large?", 1 is subtracted, and "2" indicating "No" is updated. For the survey item "a) Have you used sharing in the past?", "Yes" that is the same as that at the time of answering the questionnaire is maintained.

In a case where the individual id is "1", for the survey item "a) Have you used sharing in the past?", "No" indicating that the user has never use sharing is set. For the survey item "b) Were you not able to use sharing?", "No" indicating that the user could not use sharing is set. For the survey item "c) Do you think the inventory quantity is large?", "4" indicating "Yes" is set.

Under such circumstances, it is assumed that an experience that the number of vehicles in the simulation is large and sharing has been able to be used has occurred for a person whose individual id is "1". Then, the use experience update unit 47 adds or subtracts the value to or from the value of the answer information of the questionnaire according to the use experience, and updates the value. Here, according to the experience generated by the simulation, "Yes" indicating "I have used" is updated for the survey item "a) Have you used sharing in the past?". For the survey item "c) Do you think the inventory quantity is large?", 1 is added, and "5" indicating "Strongly yes" is updated. Note that for the survey item "b) Were you not able to use sharing?", "No" that is the same as at the time of answering the questionnaire is maintained.

As described above, the experience can be expressed by presence or absence of Yes/No or the like, and can be expressed by ranking such as 1 to 5.

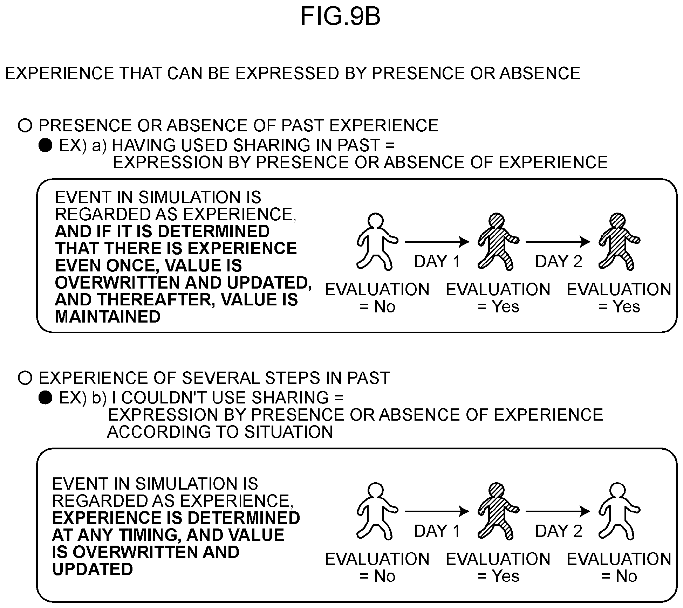

FIG. 9B illustrates a case where experience can be expressed by presence or absence. The experience that can be expressed by presence or absence can be expressed by a binary value. The upper part of FIG. 9B illustrates an example of the presence or absence of past experience. As an example, there is a case of "a) Have you used sharing in the past?" illustrated in FIG. 9A. In such a case, the use experience update unit 47 regards the target event in the simulation as an experience, and if it is determined that there is an experience even once, "Yes" is overwritten and updated, and thereafter, the value is maintained. Here, since it is determined that there is sharing experience on Day 2, the value of "Yes" is maintained on and after Day 2.

In addition, the lower part of FIG. 9B illustrates an example in which experience according to a situation appearing at the time of simulation can be expressed by presence or absence. As an example, there is a case of "b" Were you not able to use sharing?" illustrated in FIG. 9A. In such a case, the use experience update unit 47 regards a target event in the simulation as an experience, determines the experience at an arbitrary timing, and updates the value. Here, since it is determined that there is an experience that the user has not been able to use sharing on Day 2, "Yes" is updated, and since there is no experience that the user has not been able to use sharing on Day 3, "No" is updated.

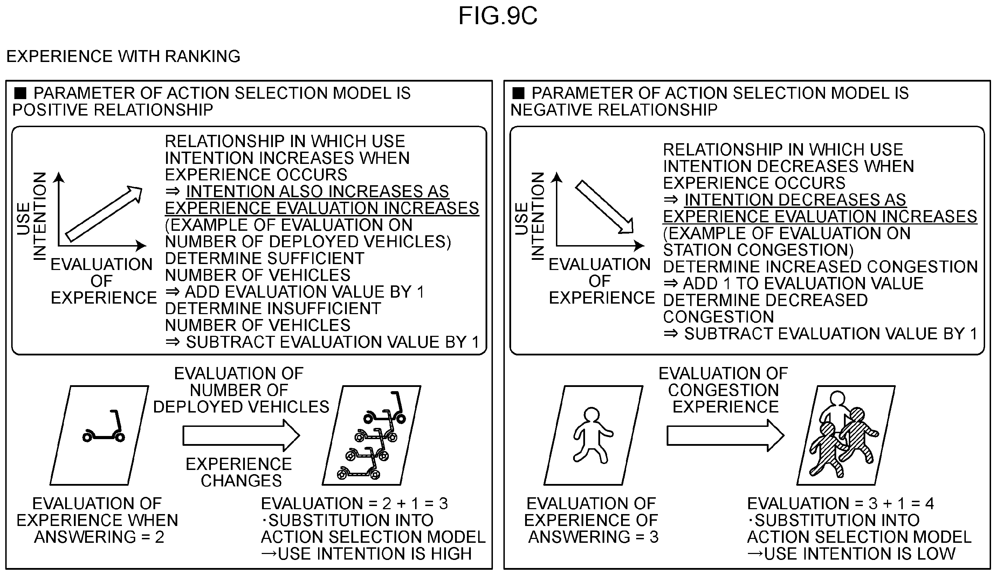

FIG. 9C illustrates a case where experience involves ranking. The experience with ranking can be represented, for example, by a numerical value of an ordinal scale of 1 to 5. The left part in FIG. 9C illustrates the update of the experience in a case where the parameter of the explanatory variable (survey item) set in the action selection model has a positive relationship. In such a case, there is a relationship in which the use intention increases when experience occurs. That is, when the experience evaluation increases, the use intention also increases. As an example, there is a case of "c) Is the inventory quantity large?" illustrated in FIG. 9A. In such a case, the use experience update unit 47 evaluates the inventory quantity, adds 1 to the evaluation value when determining that the inventory quantity is sufficient, and subtracts 1 from the evaluation value when determining that the number of inventories is insufficient. That is, it is assumed that the evaluation of the experience with respect to the inventory quantity when the questionnaire is answered is "2". When it is determined that the inventory quantity is sufficient, the evaluation of the experience for the inventory quantity is updated to "3" by adding "2" to 1. Therefore, when this evaluation value is substituted into the action selection model, the use intention becomes high.

The right part in FIG. 9C illustrates the update of the experience in a case where the parameter of the explanatory variable (survey item) set in the action selection model has a negative relationship. In such a case, the use intention is lowered when experience occurs. That is, when the experience evaluation increases, the use intention decreases. As an example, there is a case where "station congestion" is asked. In such a case, the use experience update unit 47 evaluates the congestion experience, adds 1 to the evaluation value when determining that the congestion is large, and subtracts 1 from the evaluation value when determining that the congestion is small. That is, it is assumed that the evaluation of the experience of congestion of the station at the time of answering the questionnaire is "3". When it is determined that the congestion is large, the evaluation of the experience of the station with respect to the congestion is updated to "4" by adding "3" to 1. Therefore, when this evaluation value is substituted into the action selection model, the use intention is lowered.

Returning to FIG. 5, the measure evaluation unit 48 evaluates a measure on the basis of the simulation result. For example, the measure evaluation unit 48 specifies a state of a target for introducing a measure on the basis of a simulation result. The measures mentioned here refer to, for example, adjustment (redeployment) of the number of mobilities to the station, adjustment of battery recovery of a mobility, and the like. In a case where the measure is to adjust the number of mobilities to the station, the target to introduce the measure refers to, for example, the number of deployed vehicles to each station and the number of people who intend to use. In addition, in a case where the measure is to adjust the battery recovery of a mobility, it refers to, for example, a remaining battery level of a mobility of each station. Then, the measure evaluation unit 48 displays information regarding the evaluation result of the measure on the display screen based on the state of the target for introducing the measure.

As an example, the measure evaluation unit 48 aggregates, for a person whose departure place is in the vicinity, the number of people who intend to use the service which is output by the action selection model for each station. The measure evaluation unit 48 generates a priority order list of the stations redeployed in descending order of "number of intended people - number of deployed vehicles" (insufficient number of vehicles) for each station. That is, the measure evaluation unit 48 generates the priority order list of the stations redeployed in descending order of the insufficient number of vehicles. Then, the measure evaluation unit 48 selects a target station i to be prioritized from the priority order list. Then, the measure evaluation unit 48 performs the redeployment processing from the lowest station j in the priority order list. In the redeployment processing, if the distance between the station i and the station j is an allowable distance, if the number of deployed vehicles of the station j is large, the information regarding the evaluation result of the measure is set so as to move one vehicle from the station j to the station **i.** In the redeployment processing, if the number of deployed vehicles of the station i is still insufficient, if the number of deployed vehicles of the station j is large, one vehicle is moved from the station j to the station i. On the other hand, in the redeployment processing, if the number of deployed vehicles of the station i is still insufficient, when the number of deployed vehicles of the station j runs out, the next lower station j is selected, and the redeployment processing is performed. In this manner, the measure evaluation unit 48 performs the redeployment processing in descending order of the insufficient number of vehicles. Then, the measure evaluation unit 48 displays information regarding the evaluation result of the measure on the display screen. Note that the measure evaluation unit 48 may use the inventory quantity instead of the number of deployed vehicles.

Furthermore, the measure evaluation unit 48 updates the information regarding the evaluation result of the measure with respect to the vehicle information 35 on the basis of the displayed display screen. As a result, the measure evaluation unit 48 can support evaluation and examination of measures for each station. The operator of the service may manually update the information related to the evaluation result of the measure with respect to the vehicle information 35 while referring to the display screen.

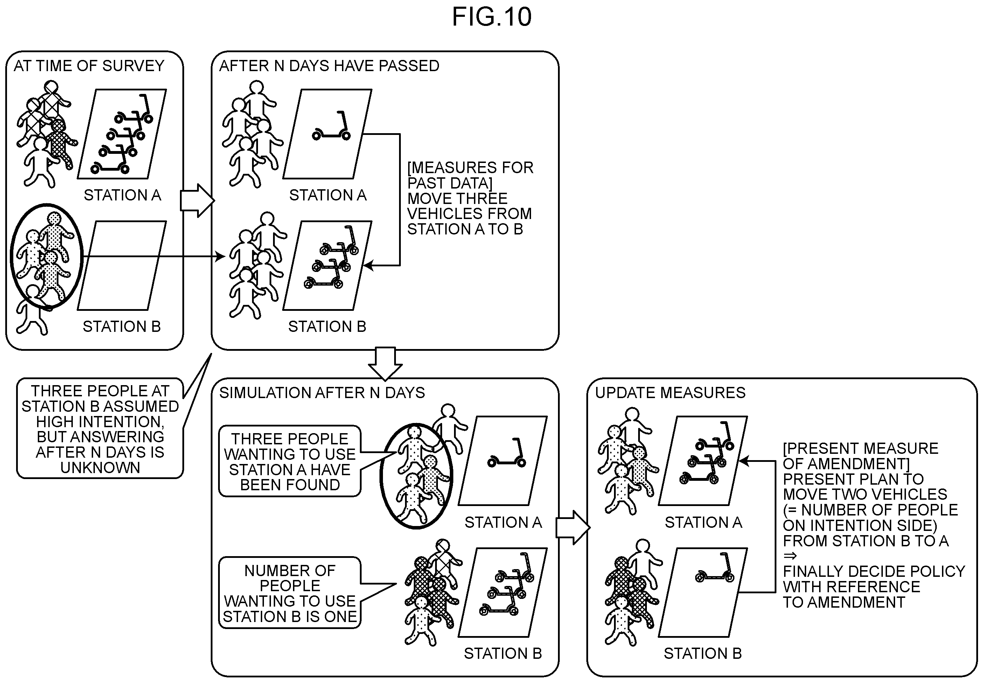

Here, an example of the measure evaluation processing will be described with reference to FIG. 10. FIG. 10 is a diagram illustrating an example of measure evaluation processing according to the present embodiment. As illustrated in FIG. 10, three people at the station B express the use intention of the service at the time of survey of a questionnaire. Therefore, when N days elapse from the time of the survey, the operator of the service implements a redeployment measure to move three mobilities from the station A to the station B. It is assumed that one mobility is deployed in the station A and three mobilities are deployed in the station B.

Under such circumstances, it is assumed that the simulation is performed N days after the survey. Then, three people who have expressed the use intention of the service have been found in the station A. In the station B, one person has expressed the use intention of the service. Therefore, the measure evaluation unit 48 presents an amendment of the measure of moving two units from the station B to the station A. Then, the operator of the service can refer to the presented amendment and finally decide the policy of the measure.

### Flowchart of simulation

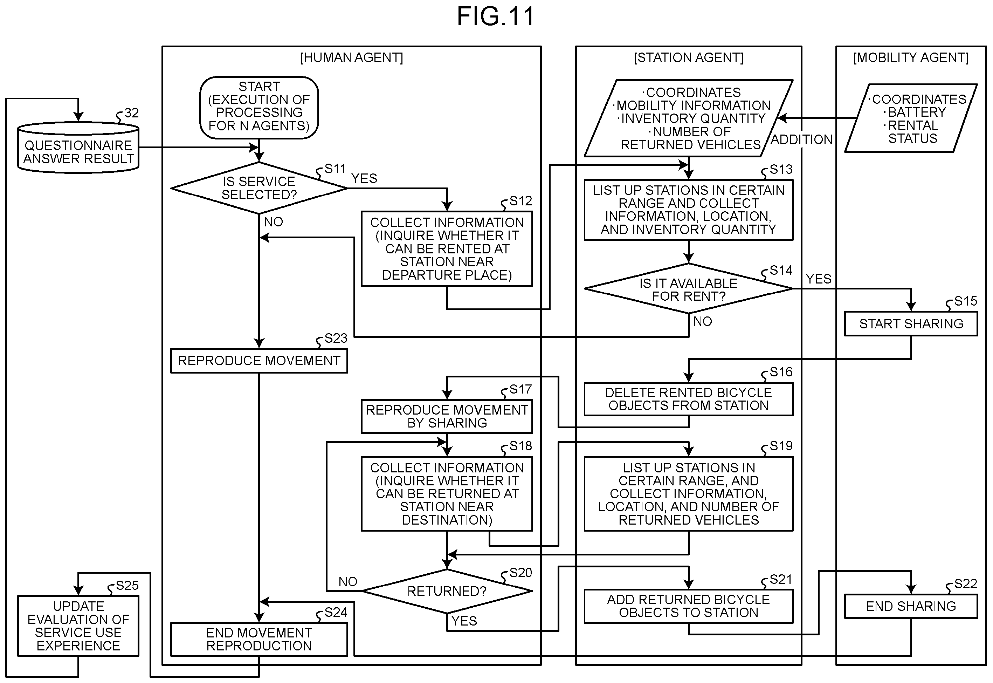

Here, a flowchart of a simulation in the mobility sharing service performed by the information processing device 10 will be described with reference to FIG. 11. FIG. 11 is a diagram illustrating an example of a flowchart of simulation according to the present embodiment. Note that it is assumed that the action selection model has already been trained. In addition, in FIG. 11, an agent corresponding to a person (human agent), an agent corresponding to a station (station agent), and an agent corresponding to a mobility (mobility agent) will be described separately.

As illustrated in FIG. 11, the information processing device 10 executes processing of agents corresponding to N people. The following flowcharts are processing of an agent corresponding to one person. In the human agent, the information processing device 10 determines whether to select a service for the target agent (step S11). For example, the information processing device 10 inputs the questionnaire answer result 32 of the person corresponding to the target agent to the trained action selection model, and estimates the use intention of the service. Then, the information processing device 10 determines to select the service in a case where the use intention of the service indicates to use the service, and determines not to select the service in a case where the use intention of the service indicates not to use the service.

In a case where it is determined that the service is selected (step S11; Yes), the information processing device 10 inquires of the station agent about information collection as to whether the station near the departure place can rent a mobility (step S12). The departure place of the target agent is included in, for example, the questionnaire answer result 32.

In the station agent, the information processing device 10 lists stations in a certain range and collects information (step S13). The collected information includes, for example, a location of each station, the inventory quantity of mobilities, and the like. Then, the information processing device 10 refers to the collected information and determines whether the station near the departure place can rent a mobility (step S14). In a case where it is determined that a mobility is not available for rent (step S14; No), the information processing device 10 proceeds to step S23 to start movement with another mobility. For example, another mobility may be searched from the questionnaire answer result 32.

On the other hand, in a case where it is determined that a mobility is available for rent (step S14; Yes), the information processing device 10 starts sharing with the rented mobility (step S15). Then, the information processing device 10 deletes the amount of rented bicycle objects corresponding to the mobility as the service target from the inventory quantity at the station (step S16).

In the human agent, the information processing device 10 reproduces movement of a person and mobility for sharing (step S17). That is, the information processing device 10 generates the use experience of a service of the mobility for the target agent. Then, the information processing device 10 inquires of the station agent about information collection as to whether the return can be made at a station near the destination (step S18). The destination of the target agent is included in, for example, the questionnaire answer result 32.

In the station agent, the information processing device 10 lists stations in a certain range and collects information (step S19). The collected information includes, for example, the location of each station, the number of returned mobilities, the upper limit number of vehicles, and the like. Then, the information processing device 10 refers to the collected information and determines whether the vehicle can be returned at a station near the destination by using the upper limit number of vehicles of the collected information (step S20). In a case where it is determined that the return is not possible (step S20; No), the information processing device 10 proceeds to step S18 to collect information.

On the other hand, in a case where it is determined that the return is possible (step S20; Yes), the information processing device 10 adds the return amount to the inventory quantity at the station in order to return the bicycle object to the station where the bicycle object can be returned (step S21). Then, the information processing device 10 ends the sharing in the mobility (step S22). Then, the information processing device 10 proceeds to step S24.

In a case where the human agent determines not to select the service (step S11; No), the information processing device 10 reproduces the movement with another mobility (step S23). Note that another mobility may be searched from the questionnaire answer result 32. Then, the information processing device 10 proceeds to step S24.

In step S24, the information processing device 10 ends the movement reproduction (step S24). Then, the information processing device 10 updates the evaluation of the use experience of a service to the questionnaire answer result 32 (step S25).

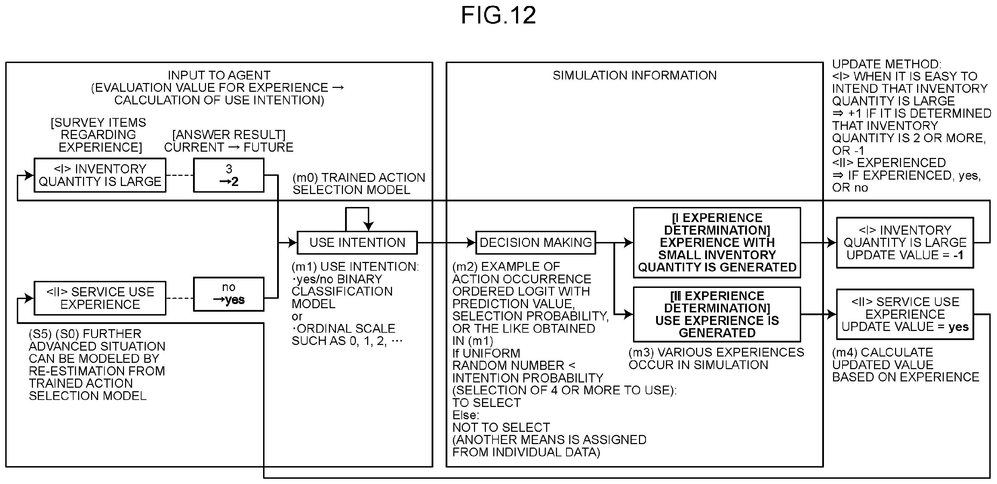

Here, a specific example of updating the evaluation of the use experience for the target agent will be described with reference to FIG. 12. FIG. 12 is a diagram illustrating a specific example of the use experience update according to the present embodiment. The questionnaire answer result 32 includes "<I> Is the inventory quantity large?" and "<II> Have you ever used the service" as survey items regarding service experience. In the current answer result to <I>, "3" indicating that the inventory quantity is neither large nor small is set. In the current answer result to <II>, "No" indicating that there is no service use experience is set.

Under such circumstances, the information processing device 10 inputs the questionnaire answer result 32 of the person corresponding to the target agent to the trained action selection model (m0), and estimates the use intention of the service. The method (m1) of the use intention may be represented by a binary value of "yes" or "no", or may be represented by an ordinal scale such as 1 to 5.

Then, the information processing device 10 generates an action with the prediction value, the selection probability, or the like obtained in the use intention (m1) (m2). The action mentioned here includes, for example, movement by mobility of a service target, movement by another moving means, and the like. Then, the information processing device 10 generates various use experiences of the service for the target agent (m3).

Then, the information processing device 10 calculates an update value on the basis of the use experience (m4). A method of calculating the update value is, for example, as follows. For <I>, in a case where it is easy to intend that the inventory quantity is large (for example, the parameter <I> of the action selection model is positive), the updated value is calculated as "+1" if it is determined that the inventory quantity is two or more, and "-1" if it is determined otherwise. For <II>, the update value is calculated as "yes" if there is use experience, and "no" if there is no use experience.

Here, it is assumed that the use experience of a service has occurred, but an experience that the inventory quantity of mobilities of a service target is small has occurred. Then, the information processing device 10 calculates an update value for <I> as "-1" on the basis of the update method. In addition, the information processing device 10 calculates an update value for <II> as "yes" on the basis of the update method.

Then, the information processing device 10 updates the evaluation of the use experience of a service to the questionnaire answer result 32. Here, for <I>, "2" obtained by subtracting "1" from "3" is updated. For <2>, "yes" is updated.

As a result, the information processing device 10 can update the change in the use experience of a service without reviewing the questionnaire.

### Flowchart of measure evaluation processing

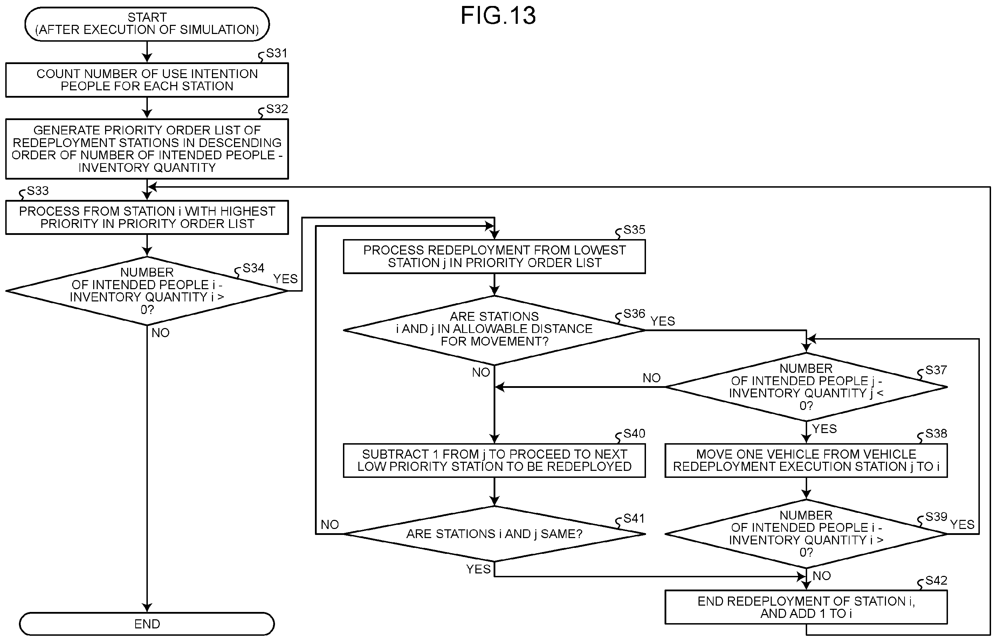

Here, a flowchart of the measure evaluation processing performed by the information processing device 10 will be described with reference to FIG. 13. FIG. 13 is a diagram illustrating an example of a flowchart of the measure evaluation processing according to the present embodiment. Note that it is assumed that the simulation has been executed. In addition, in the flowchart, a case where the measure evaluation processing is executed using the inventory quantity will be described, but the deployed number of vehicles may be used instead of the inventory quantity.

As illustrated in FIG. 13, the information processing device 10 counts the number of use intention people for people located in the vicinity of each station for each station (step S31). The number of use intention people is the number of people who intend to use among the use intention output by the action selection model. The information processing device 10 generates a priority order list of the redeployment stations in descending order of "number of intended people - inventory quantity" (step S32). That is, the information processing device 10 generates the priority order list of the redeployment stations in descending order of the insufficient number.

The information processing device 10 performs processing from the station i with the highest priority in the highest priority order list (step S33). The information processing device 10 determines whether "number of intended people i - inventory quantity i" is larger than 0 (step S34). That is, the information processing device 10 determines whether there is an inventory shortage at the station i prioritized for redeployment. Here, the number of intended people i is the number of use intention people of the station i. The inventory quantity i is the inventory quantity of the station i.

In a case where it is determined that "number of intended people i - inventory quantity i" is larger than 0 (step S34; Yes), the information processing device 10 processes the following from the lowest station j in the redeployment priority order list in order to generate a redeployment plan (step S35). This is because the inventory is insufficient at the station i prioritized for redeployment. The information processing device 10 determines whether the stations i and j are at an allowable distance for movement (step S36). The coordinate data on the map in the road network map information 34 of the stations i and j is stored in, for example, the vehicle information 35. Whether the movement is an allowable distance may be determined using a predetermined specified value.

In a case where it is determined that the stations i and j are within the allowable distance for movement (step S36; Yes), the information processing device 10 determines whether "number of intentioned people j - inventory quantity j" is smaller than 0 (step S37). That is, the information processing device 10 determines a surplus of inventory on the station j side. In a case where it is determined that "number of intended people j - inventory quantity j" is smaller than 0 (step S37; Yes), the information processing device 10 moves one vehicle from the station j to the station i in order to redeploy the vehicle (step S38). This is because there is a surplus in inventory on the station j side. For example, the information processing device 10 sets information regarding the evaluation result of the measure so as to move one vehicle from the station j to the station i.

Then, the information processing device 10 determines whether "number of intentioned people i - inventory quantity i" is larger than 0 (step S39). That is, the information processing device 10 determines an inventory shortage at the station i to be redeployed. In a case where it is determined that "number of intended people i - inventory quantity i" is larger than 0 (step S39; Yes), the information processing device 10 proceeds to step S37 since the inventory is still insufficient at the station i prioritized for redeployment.

On the other hand, in a case where it is determined that "number of people intention i - inventory quantity i" is not larger than 0 (step S39; No), the information processing device 10 proceeds to step S42 since the inventory is not insufficient at the station i prioritized for redeployment.

In a case where it is determined in step S36 that the stations i and j are not within the allowable distance for movement (step S36; No), the information processing device 10 subtracts 1 from j in order to advance the next redeployment to a low-priority station (step S40). Then, the information processing device 10 determines whether the stations i and j are the same (step S41). In a case where it is determined that the stations i and j are not the same (step S41; No), the information processing device 10 proceeds to step S35.

On the other hand, in a case where it is determined that the stations i and j are the same (step S41; Yes), the information processing device 10 proceeds to step S42 to end the redeployment of the station i prioritized for redeployment. This is because the station i cannot be redeployed by the station j.

In step S42, the information processing device 10 ends the redeployment of the station i and adds 1 to i (step S42). Then, the information processing device 10 proceeds to step S33 to process the next station i to be redeployed.

In a case where it is determined in step S34 that "number of intended people i - inventory quantity i" is not larger than 0 (step S34; No), the information processing device 10 ends the measure evaluation processing since the inventory is not insufficient at the station i prioritized for redeployment.

Note that, in the flowchart illustrated in FIG. 13, the case where the information processing device 10 automatically implements the redeployment measure for each station has been described, but the present invention is not limited thereto, and the redeployment measure for each station may be implemented using a user interface between the user and the information processing device 10.

### Specific example of measure evaluation

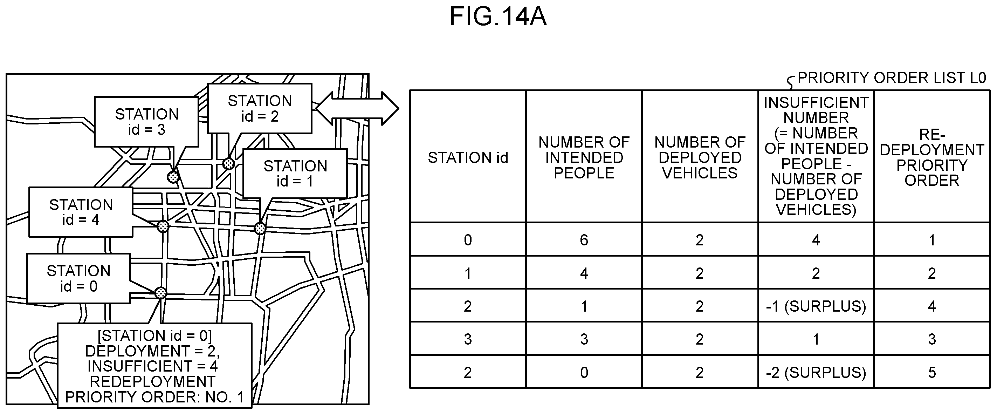

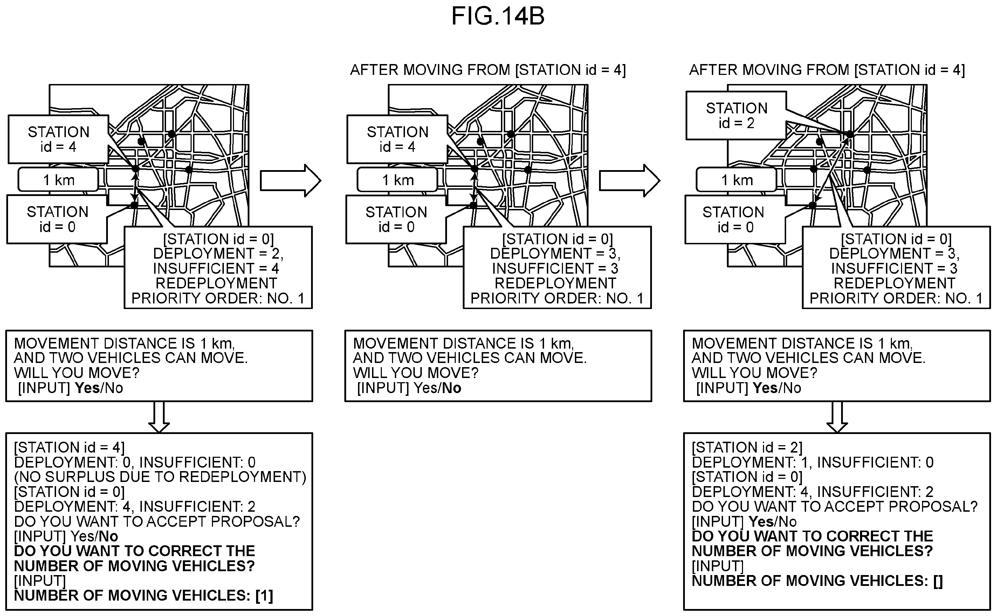

FIGS. 14A and 14B are diagrams illustrating specific examples of measure evaluation according to the present example. Note that, in FIGS. 14A and 14B, a case where a redeployment measure for each station is evaluated using a user interface between the user and the information processing device 10 will be described.

The right part in FIG. 14A illustrates a priority order list L0 in each station after the simulation is performed. For example, the information processing device 10 calculates a relationship between the number of intended people and the number of deployed vehicles for each station. That is, the information processing device 10 generates the priority order list L0 for each station redeployed by using the insufficient number indicating a value obtained by subtracting the number of deployed vehicles from the number of intended people. The redeployment priority order included in the priority order list L0 is assigned in order from the one with the larger insufficient number of vehicles. That is, the information processing device 10 generates the priority order list L0 having a higher priority order in descending order of the insufficient number. Here, in the priority order list L0, as an example, in a case where the station id is "0", "6" is set as the number of intended people, **"2"** is set as the number of deployed vehicles, **"4"** is set as the insufficient number of vehicles, and the highest priority **"1"** is set as the redeployment priority order. Further, regarding the relationship between the station id and the redeployment priority, the station id "0" indicates the first place as the priority. Then, the station id "1" indicates the second place as the priority, the station id "3" indicates the third place as the priority, and the station id "2" indicates the fourth place as the priority. Then, the station id "4" indicates the lowest fifth place as the priority. Note that the inventory quantity may be used instead of the number of deployed vehicles.

In the left part of FIG. 14A, the simulation result is displayed on the screen. That is, the simulation result is expressed on a map in the road network map information 34. Each station is arranged on the map. Based on the priority order list L0, the number of deployed vehicles, the insufficient number, and the redeployment priority order are associated with each station. Here, as an example, in a case where the station id is "0", "two" is associated with the station id "0" as the number of deployed vehicles, "four" as the insufficient number, and "first" as the redeployment priority order.

Under such circumstances, as illustrated in the left part of FIG. 14B, the information processing device 10 performs the measure evaluation processing on the basis of the priority order list L0. As illustrated in FIG. 14B, the information processing device 10 performs processing from the station having the station id "0" with a redeployment priority having the largest value of "number of intended people - number of deployed vehicles". The information processing device 10 selects the station id "4" having the lowest redeployment priority. Here, the station id "0" and the station id "4" are highlighted.

The information processing device 10 determines whether the station id "0" and the station id "4" are within an allowable distance for movement. Here, since the movement distance between the station id "0" and the station id "4" is "1 km", the information processing device 10 determines that the movement is an allowable distance. Then, since two vehicles are available in the station id "4" on the basis of the priority order list L0, the information processing device 10 prompts the user to answer to "Two vehicles are available within a movement distance of 1 km. Will you move?". Here, "Yes" indicating movement is input.

Then, the information processing device 10 displays "0" as the number of deployed vehicles and "0" as the insufficient number for the station id "4" (there is no surplus in redeployment). In addition, the information processing device 10 displays "4" as the number of deployed vehicles and "2" as the insufficient number for the station id "0". Then, the information processing device 10 prompts the user to answer to "Do you want to accept proposal?". Here, "No" indicating no adoption is input. Furthermore, the information processing device 10 prompts the user to answer "Do you want to correct the number of moving vehicles?". Here, "1" is input as the number of moving vehicles.

As a result, as illustrated in the middle part in FIG. 14B, the information processing device 10 associates "3" as the number of deployed vehicles, "3" as the insufficient number, and "1" as the redeployment priority with the station id "0". Then, since one vehicle is still available in the station id "4" on the basis of the priority order list L0, the information processing device 10 prompts the user to answer to "One vehicle is available within a movement distance of 1 km. Will you move?". Here, "No" indicating no movement is input.

Next, as illustrated in the right part in FIG. 14B, the information processing device 10 selects the station id "2" having the next smallest redeployment priority order. Here, the station id "0" and the station id "2" are highlighted.

The information processing device 10 determines whether the station id "0" and the station id "2" are within an allowable distance for movement. Here, since the movement distance between the station id "0" and the station id "2" is "2 km", the information processing device 10 determines that the movement is an allowable distance. Then, since one vehicle is available in the station id "2" on the basis of the priority order list L0, the information processing device 10 prompts the user to answer to "One vehicle is available within a movement distance of 2 km. Will you move?". Here, "Yes" indicating movement is input.

Then, the information processing device 10 displays "1" as the number of deployed vehicles and "0" as the insufficient number for the station id "2" (there is no surplus in redeployment). In addition, the information processing device 10 displays "4" as the number of deployed vehicles and "2" as the insufficient number for the station id "0". Then, the information processing device 10 prompts the user to answer to "Do you want to accept proposal?". Here, "Yes" indicating adoption is input.

In this manner, the information processing device 10 can continue the measure evaluation processing and cause the user to perform trial and error of examination of a measure plan for redeployment of the vehicle in each station. That is, the service operator can perform trial and error of the examination of the measure plan on the basis of the change in the use intention of the virtual service.

### Example of effect of simulation

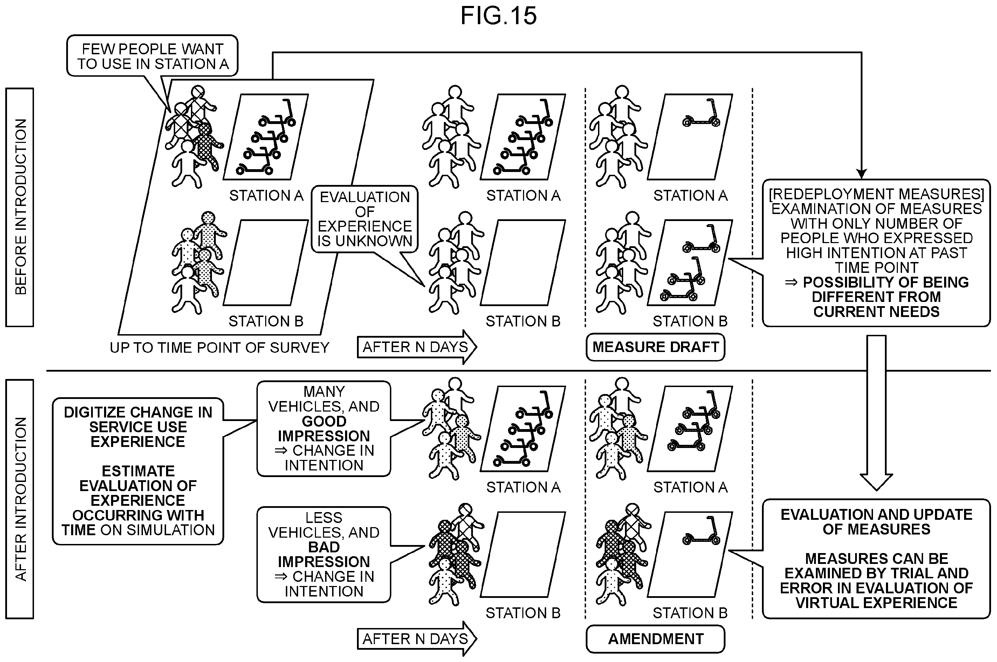

FIG. 15 is a diagram illustrating an example of an effect of the simulation according to the present embodiment. The upper part in FIG. 15 illustrates a case where a measure for redeployment before introduction of simulation according to the present embodiment is implemented. As illustrated in the upper part of FIG. 15, before introduction of the simulation, the service operator examines a measure for redeployment only by the number of people who have expressed a high use intention until the time of questionnaire survey. Therefore, there is a possibility that the number of people who express a high use intention is different between the time of the questionnaire survey and the current time point N days after the time of the questionnaire survey, and the need for redeployment is different.

The lower part of FIG. 15 illustrates a case where a measure for redeployment after introduction of the simulation according to the present embodiment is implemented. As illustrated in the lower part of FIG. 15, after the introduction of the simulation, the information processing device 10 can digitize the change in the use experience of a service and estimate the evaluation of the experience that occurs with the lapse of time in the simulation. In addition, the information processing device 10 can examine a measure for redeployment to be performed by trial and error in evaluation of experience. That is, the information processing device 10 can examine the measure plan to be performed by trial and error on the basis of the change in the use intention of the virtual service. As a result, the information processing device 10 can determine a measure for a service at no cost.

### Effects

As described above, in the digital twin in which the real world is reproduced on the virtual space, the information processing device 10 generates the use experience of a service for the agent corresponding to a person by performing a simulation regarding the use of the service by the agent corresponding to the person existing in the real world. The information processing device 10 sets information regarding the use intention of the service possessed by the agent corresponding to the person on the basis of the generated use experience. As a result, the information processing device 10 can determine a measure for a service at no cost.

In addition, the information processing device 10 acquires the information regarding the use intention of the person from the storage unit 30 that stores the information regarding the use intention of the service. The information processing device 10 generates an action selection model indicating whether the person uses the service by using the acquired information regarding the use intention. Then, in the information processing device 10, in the processing of generating the use experience of a service, a simulation regarding the use of the service of the agent corresponding to the target person is performed using the generated action selection model, thereby generating information regarding the use experience of a service in the target person. Then, in the processing of setting the information regarding the use intention of the service, the information regarding the use intention of the target person stored in the storage unit 30 is updated using the generated information regarding the use experience of a service. As a result, the information processing device 10 can perform the simulation regarding the use of the service of the target person again by updating the information regarding the use intention of the target person. As a result, the information processing device 10 can perform a simulation regarding the use of the service in consideration of the change in the use experience of a service without conducting the survey (questionnaire) again. Furthermore, since the information processing device 10 can reduce the number of surveys (questionnaires), it is possible to reduce the time and cost for determining a measure plan.

Furthermore, in the information processing device 10, in the processing of generating the action selection model, the action selection model indicating whether the person uses the service is generated using the updated information regarding the use intention. Then, in the processing of performing the simulation, the simulation of the target person is performed using the generated action selection model in the digital twin in which the real world and the virtual space are time-synchronized. As a result, the information processing device 10 can generate an accurate action selection model by generating the action selection model using the updated information regarding the use intention.

Furthermore, the information processing device 10 receives information regarding a condition of a measure in the service to be introduced into the real world. The information processing device 10 generates a digital twin that reproduces the real world on the virtual space on the basis of the received information regarding the condition of the measure. Then, in the processing of performing the simulation in the information processing device 10, the simulation regarding the use of the service of the target person is performed using the generated action selection model in the generated digital twin. Then, the information processing device 10 specifies the state of the introduction target of the measure on the basis of the result of the performed simulation, and displays information regarding the verification result of the measure on the display screen on the basis of the state of the introduction target of the measure. As a result, the information processing device 10 can cause a service operator to efficiently examine a measure plan.

Furthermore, in the information processing device 10, in the processing of specifying the state of the introduction target of the measure, the number of deployed mobile bodies as the introduction target of the service is acquired from the result of the simulation for each station that introduces the service in the digital twin. In the processing of specifying the state of the introduction target of the measure, the number of use intention people who express the service use intention is counted for each station in the digital twin. The processing of specifying the state of the introduction target of the measure includes a process of calculating the shortage number of mobile bodies from the number of use intention people and the number of mobile bodies deployed for each station. Then, in the display processing on the display screen, verification of a measure of moving the mobile bodies from a second station having the smaller shortage number of mobile bodies to a first station is executed in order from the first station having the larger shortage number of mobile bodies. Then, the information processing device 10 displays the number of deployed mobile bodies for each station on the display screen as a verification result of the measure. As a result, the information processing device 10 can cause the service operator to efficiently examine a measure plan for redeployment of the mobile body.

Furthermore, in the information processing device 10, in the processing of performing the simulation, information regarding the use intention of the target person is input to the action selection model, and information indicating whether the target person uses the mobile body to which the service is to be introduced is acquired. The processing of performing the simulation includes a process of generating information regarding service use experience of the target person by performing a simulation regarding use of the mobile body of the agent corresponding to the target person on the basis of the information indicating whether the target person uses the mobile body of the service and the inventory quantity of mobile bodies for each station that introduces the service. As a result, the information processing device 10 can perform a simulation regarding the use of the mobile body of the service in consideration of the change in the use experience of a service without conducting the survey (questionnaire) again. Furthermore, since the information processing device 10 can reduce the number of surveys (questionnaires), it is possible to reduce the time and cost for determining a measure plan.

Furthermore, in the information processing device 10, the information regarding the use intention and the information regarding the use experience are represented by stepwise numerical values for each item. As a result, the information processing device 10 can easily interpret the content of the information regarding the use intention and the information regarding the use experience.

Furthermore, in the information processing device 10, in the processing of generating the action selection model, the action selection model is generated in which the information regarding the use experience included in the attribute information and the information regarding the use intention of the person is set as the explanatory variable, and the information regarding whether the user intends to use the service included in the information regarding the use intention is set as the explained variable. As a result, the information processing device 10 can generate the action selection model for estimating the use intention of the service according to the use experience of a service.

### System

The processing procedure, the control procedure, the specific name, and the information including various data and parameters illustrated in the document or the drawings may be arbitrarily changed unless otherwise specified. Furthermore, the specific examples, distributions, numerical values, and the like described in the examples are merely examples, and may be arbitrarily changed.

In addition, specific forms of distribution and integration of the components of each device are not limited to those illustrated in the drawings. That is, all or a part of the components may be functionally or physically distributed/integrated in an arbitrary unit according to various loads, usage conditions, and the like. Furthermore, all or an arbitrary part of each processing function of each device can be realized by a central processing unit (CPU) and a program analyzed and executed by the CPU, or can be realized as hardware by wired logic.

### Hardware

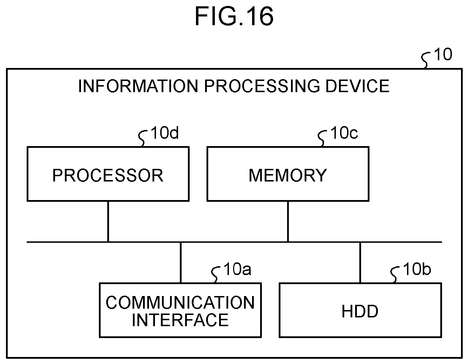

FIG. 16 is a diagram for explaining a hardware configuration example of the information processing device 10. As illustrated in FIG. 16, the information processing device 10 includes a communication interface 10a, a hard disk drive (HDD) 10b, a memory 10c, and a processor 10d. The units illustrated in FIG. 16 are connected to each other by a bus or the like.

The communication interface 10a is a network interface card or the like, and communicates with another server. The HDD 10b stores programs and DBs for operating the functions illustrated in FIG. 6.

The processor 10d is a hardware circuit that reads a program for executing the processing similar to the processing units illustrated in FIG. 5 from the HDD 10b or the like and develops the program in the memory 10c to operate the processes for executing the functions described with reference to FIG. 5 and the like. That is, this process executes functions similar to those of the processing units included in the information processing device 10. Specifically, the processor 10d reads a program having functions similar to those of the action selection model generation unit 41, the data acquisition unit 42, the action selection unit 43, the movement reproduction unit 44, the vehicle state update unit 45, the vehicle management unit 46, the use experience update unit 47, the measure evaluation unit 48, and the like from the HDD 10b or the like. Then, the processor 10d executes a process of executing processing similar to that of the action selection model generation unit 41, the data acquisition unit 42, the action selection unit 43, the movement reproduction unit 44, the vehicle state update unit 45, the vehicle management unit 46, the use experience update unit 47, the measure evaluation unit 48, and the like.

In this manner, the information processing device 10 operates as an information processing device that executes simulation by reading and executing a program that executes processing similar to each processing unit illustrated in FIG. 5. Furthermore, the information processing device 10 can also implement functions similar to those of the above-described embodiment by reading a program from a recording medium by a medium reading device and executing the read program. Note that the program referred to in this other embodiments is not limited to being executed by the information processing device 10. For example, the present embodiment may be similarly applied to a case where another information processing device executes a program or a case where the information processing device 10 and another information processing device execute a program in cooperation with each other.

In addition, a program that executes processing similar to each processing unit illustrated in FIG. 5 can be distributed via a network such as the Internet. In addition, this program can be recorded on a computer-readable recording medium such as a hard disk, a flexible disk (FD), a CD-ROM, a magneto-optical disk (MO), or a digital versatile disc (DVD), and can be executed by being read from the recording medium by the computer.

Note that the simulation of the information processing device 10 according to the above embodiment can be applied to, for example, a case of examining a deployment measure for sharing mobility that has not yet spread.

In one aspect, it is possible to determine a service measure at no cost.

## Claims

1. An information processing program causing a computer (10) to execute a process comprising:
causing an agent corresponding to a person present in a real world to generate use experience of a service by performing a simulation regarding use of the service by the agent corresponding to the person in a digital twin in which the real world is reproduced on a virtual space; and
setting information regarding use intention of the service possessed by the agent corresponding to the person based on the generated use experience.

2. The information processing program according to claim 1, wherein the process further includes:
acquiring, from a storage unit (30) that stores information regarding use intention of a person for the service, information regarding use intention; and
generating an action selection model indicating whether a person uses a service by using the acquired information regarding use intention, wherein
the generating of use experience of the service includes generating information regarding use experience of the service in a target person by performing a simulation regarding use of a service of an agent corresponding to the target person using the generated action selection model, and
the setting of information regarding use intention of the service includes updating information regarding the use intention of the target person stored in the storage unit by using the generated information regarding use experience of the service.

3. The information processing program according to claim **2,** wherein
the generating of the action selection model includes generating the action selection model indicating whether a person uses a service using the updated information regarding the use intention, and
the performing of the simulation includes performing a simulation of the target person using the generated action selection model in the digital twin in which a real world and a virtual space are time-synchronized.

4. The information processing program according to claim 3, wherein the process further includes:
receiving information regarding a condition of a measure in the service to be introduced into the real world; and
generating the digital twin that reproduces the real world in a virtual space based on the received information regarding the condition of the measure, wherein
the performing of the simulation includes performing a simulation regarding use of a service of the target person using the generated action selection model in the generated digital twin, and
the process further includes:
specifying a state of an introduction target of the measure based on a result of the performed simulation; and
displaying information regarding a verification result of the measure on a display screen based on the state of the introduction target of the measure.

5. The information processing program according to claim 4, wherein
the specifying of the state of the introduction target of the measure includes:
acquiring, in the digital twin, a number of deployed mobile bodies which is an introduction target of the service from a result of the simulation for each station that introduces the service;
aggregating, in the digital twin, a number of use intention people who intend to use a service for each of the stations; and
calculating a shortage number of the mobile bodies from the number of use intention people and the number of deployed mobile bodies for each of the stations, and
the displaying on the display screen includes:
executing verification of the measure of moving the mobile body from a second station having a smaller shortage number of mobile bodies to a first station having a large shortage number of mobile bodies in order from the first station; and
displaying, on the display screen, the number of deployed mobile bodies for each station as a verification result of the measure.

6. The information processing program according to claim 3, wherein
the performing of the simulation includes:
inputting information regarding the use intention of the target person into the action selection model to acquire information indicating whether the target person uses a mobile body that is an introduction target of a service; and
generating information regarding use experience of a service of the target person by performing a simulation regarding use of the mobile body of the agent corresponding to the target person based on the information indicating whether the target person uses the mobile body of the service and the number of deployed mobile bodies in each station that introduces the service.

7. The information processing program according to claim 2, wherein
information regarding the use intention and information regarding the use experience are represented by stepwise numerical values indicating use intention for each item.

8. The information processing program according to claim 3, wherein
the generating of the action selection model includes
generating the action selection model in which information regarding use experience included in attribute information of the person and information regarding the use intention is set as an explanatory variable, and information regarding whether a user desires to use a service included in the information regarding the use intention is set as an explained variable.

9. An information processing method causing a computer (10) to execute a process comprising:
causing an agent corresponding to a person present in a real world to generate use experience of a service by performing a simulation regarding use of the service by the agent corresponding to the person in a digital twin in which the real world is reproduced on a virtual space; and
setting information regarding use intention of the service possessed by the agent corresponding to the person based on the generated use experience.

10. An information processing device (10) comprising:
a simulation unit configured to cause an agent corresponding to a person present in a real world to generate use experience of a service by performing a simulation regarding use of the service by the agent corresponding to the person in a digital twin in which the real world is reproduced on a virtual space; and
a setting unit configured to set information regarding use intention of the service possessed by the agent corresponding to the person based on the use experience generated by the simulation unit.
